# EUROPEAN PATENT APPLICATION

(11) **EP 4 653 137 A1**
(43) Date of publication of application: **26.11.2025**
(21) Application number: 24766717.3
(22) Date of filing: 30.01.2024
(51) Int. Cl.: B24B 53/06, B24B 49/10, B24B 49/12, B24B 49/14, B24B 49/18, H01L 21/304

(54) **GRINDING STONE TRUING METHOD AND TRUING DEVICE**

(30) Priority: 09.03.2023 JP 2023036452
(71) Applicant: Tokyo Seimitsu Co., Ltd., Hachioji-shi, Tokyo 192-8515 (JP)
(72) Inventor: TSURU, Taira, Tsuchiura-shi, Ibaraki 300-0015 (JP)
(74) Representative: Seemann & Partner Patentanwälte mbB
(86) International application number: PCT/JP2024/002723
(87) International publication number: WO 2024/185342

(57) **Abstract**

A grinding stone truing device includes: a truer moving stage 25 that fixes a truer 10; a shape measurement unit 35 that measures respective shapes of the truer 10 and a grinding stone 16; a displacement evaluation unit 31 that measures displacement of the truer 10 and displacement of the grinding stone 16; a vibration measurement unit 32 that measures vibration of the truer 10 and vibration of the grinding stone 16; a machining heat evaluation unit 33 that measures a temperature and a heat flow; a control unit 30 that controls an incision amount, a rotational rate, and a position of the truer 10, based on respective measurement results from the displacement evaluation unit 31, the vibration measurement unit 32, and the machining heat evaluation unit 33; a machining condition database 37-1 that stores the respective measurement results from the displacement evaluation unit 31, the vibration measurement unit 32, and the machining heat evaluation unit 33 in association with the respective shapes of the truer 10 and the grinding stone 16 measured after truing; and a machining learning model 37-2. The grinding stone truing device enables high-precision and high-quality truing to the shape of a grinding stone having a grooved shape, so that variations in shape (quality) can be reduced.

## Description

### Field

The present invention relates to a grinding stone truing method and a grinding stone truing device for a grinding stone having a grooved shape for use in a device for chamfering the end face of a semiconductor wafer.

### Background

In recent years, semiconductor wafers and the like have been produced in high-mix low-volume production. Grinding stones having grooved shapes for use in the chamfering machining of wafers are increasingly required to meet demands for improvement of precision and improved quality for the purpose of high-mix low-volume production, improved wafer quality, and higher yields.

In addition, semiconductors formed with silicon carbide (SiC), which is a compound of carbon (C) and silicon (Si), and other durable materials that have ultra-wide band gaps (UWBG) and strong interatomic bonds of crystals, such as gallium nitride (GaN), gallium oxide, AlGaN, and diamond, are expected as semiconductor materials that are more suitable to small-sized, low-power consuming, high-efficiency power elements and high-frequency elements and are higher in resistance to radioactive rays than silicon semiconductors are. Thus, the practical utilization of such semiconductors has been progressing. In particular, for UWBG materials, such as 4H-SiC, which are difficult-to-machine materials, grinding stones are strongly required to have highly precise and higher quality grooved shapes.

In chamfering machining in the process of manufacturing semiconductor wafers, repetition of truing a grinding stone by a truer and measuring the edge shape of a wafer after grinding is required until the wafer has a desired shape.

As finish machining to the outer chamfer of a semiconductor wafer, it has been known that so called helical grinding is performed, in which the grinding stone is inclined to the wafer and the chamfer is ground, in order to prevent grinding marks from occurring in the circumferential direction. Note that, depending on a shape formed to a grinding stone by truing, helical grinding requires subtle adjustments and time and thus needs a skilled and dedicated person.

Patent Literature 1 states that, in truing for helical grinding in which a groove is formed using a truer, in order to improve transfer rate and mechinability as well as the precision of a groove based on the truer, the upper portion or lower portion of a groove formed on the grinding stone is machined by the truer, and then the truer is repeatedly lowered or raised in the thickness direction relative to the grinding stone.

In addition, it has been known that truing is performed using a laser beam. Patent Literature 2 describes truing with a laser beam, in which, for less thermal influence on a target tool and high machining precision, an ultrashort pulsed laser, such as a femtosec-ond laser, is used and the truing is performed in a predetermined range of front and behind parts with respect to the focal point of the laser beam in the travel direction of the laser beam.

### Citation List

### Patent Literature

Patent Literature 1: Japanese Patent Application Laid-Open No. 2022-325
Patent Literature 2: Japanese Patent Application Laid-Open No. 2015-98041

### Summary

### Technical Problem

According to the technology described in Patent Literature 1 in the above conventional technologies, a skilled and dedicated person is required to adjust the movement of the truer in truing to the grinding stone for chamfering machining. In addition, with difficult-to-machine materials, such as SiC, the machining is timeconsuming, making it difficult to form the desired shape. Furthermore, the grinding stone has large variations in shape (creation) due to truing.

In addition, with the technology described in Patent Literature 2, it is difficult to widen the irradiation range, and the part that can be trued at one time is small, making it impossible to apply truing to the entire grinding stone. Enhancing the precision of the shape of the entire grinding stone having a grooved shape has not been taken into consideration.

For solution to the disadvantages of the above conventional technologies, an object of the present invention is to provide a grinding stone truing device and a grinding stone truing method enabling high-precision and high-quality truing to the shape of a grinding stone having a grooved shape with reduced variations in shape (quality).

### Solution to Problem

For achievement of the above object, according to the present invention, provided is a grinding stone truing method for a grinding stone for use in a device for chamfering a wafer, the grinding stone truing method including: determining a target shape of the grinding stone; and truing the grinding stone to achieve the target shape, based on respective shapes of a truer and the grinding stone measured at least before machining and a displacement condition indicating a relationship in applied force and displacement between the truer and the grinding stone.

Preferably, the grinding stone truing method further includes monitoring, during the truing, displacement, vibration, and machining heat of the truer and displacement, vibration, and machining heat of the grinding stone.

Furthermore, in the grinding stone truing method, preferably, the displacement condition of the truer is axial displacement.

Furthermore, in the grinding stone truing method, preferably, the displacement condition of the grinding stone is displacement due to bending or torsion.

Preferably, the grinding stone truing method further includes: measuring the respective shapes of the truer and the grinding stone after the truing; comparing the measured respective shapes of the truer and the grinding stone with the respective target shapes of the truer and the grinding stone; grinding the wafer with the grinding stone when the respective shapes of the truer and the grinding stone fall within an acceptable range; and making a determination in quality.

Preferably, the grinding stone truing method further includes: storing, as a machining condition database, a result from the monitoring in association with the respective shapes of the truer and the grinding stone measured after the truing; and constructing a machining learning model based on the machining condition database.

In addition, according to the present invention, provided is a grinding stone truing device for a grinding stone for use in a device for chamfering a wafer, the grinding stone truing device including: a truer moving stage that fixes a truer such that a rotational axis, an X axis, a Y axis, and a Z axis are made variable; a shape measurement unit that measures respective shapes of the truer and the grinding stone; a displacement evaluation unit that measures displacement of the truer and displacement of the grinding stone; a vibration measurement unit that measures vibration of the truer and vibration of the grinding stone; a machining heat evaluation unit that measures a temperature and a heat flow; a control unit that controls an incision amount, a rotational rate, and a position of the truer, based on respective measurement results from the displacement evaluation unit, the vibration measurement unit, and the machining heat evaluation unit; a machining condition database that stores the respective measurement results in association with the respective shapes of the truer and the grinding stone measured after truing; and a machining learning model constructed based on the machining condition database.

Furthermore, in the grinding stone truing device, the control unit performs the truing to the grinding stone to achieve a target shape, based on the respective shapes of the truer and the grinding stone measured by the shape measurement unit at least before machining, axial displacement of the truer, and displacement due to bending or torsion of the grinding stone.

### Advantageous Effects of Invention

According to the present invention, a target shape is determined for a grinding stone, and truing is performed to the grinding stone to achieve the target shape, based on respective shapes of a truer and the grinding stone measured at least before machining and a displacement condition between the truer and the grinding stone. Thus, a grinding stone truing device and a grinding stone truing method can be obtained that enable high-precision and high-quality truing to the shape of a grinding stone having a grooved shape with reduced variations in shape (quality).

### Brief Description of Drawings

FIG. 1 is a view illustrating a model for force-to-displacement between a truer and a grinding stone according to an embodiment of the present invention.
FIG. 2 is a block diagram illustrating the entire system configuration of a truing device according to the embodiment.
FIG. 3 is an explanatory view illustrating a procedure of chamfering machining to the end face of a wafer.
FIG. 4 is an explanatory view for factors related to the precision of machining at the time of truing.
FIG. 5 is an explanatory view illustrating deformation due to machining force at the time of truing the grinding stone and measurement thereof.
FIG. 6 is an explanatory view for positioning between the truer and the grinding stone according to the embodiment.
FIG. 7 is a configuration view of a positioning unit according to the embodiment.
FIG. 8 is a flowchart of a truing method according to the embodiment.

### Description of Embodiments

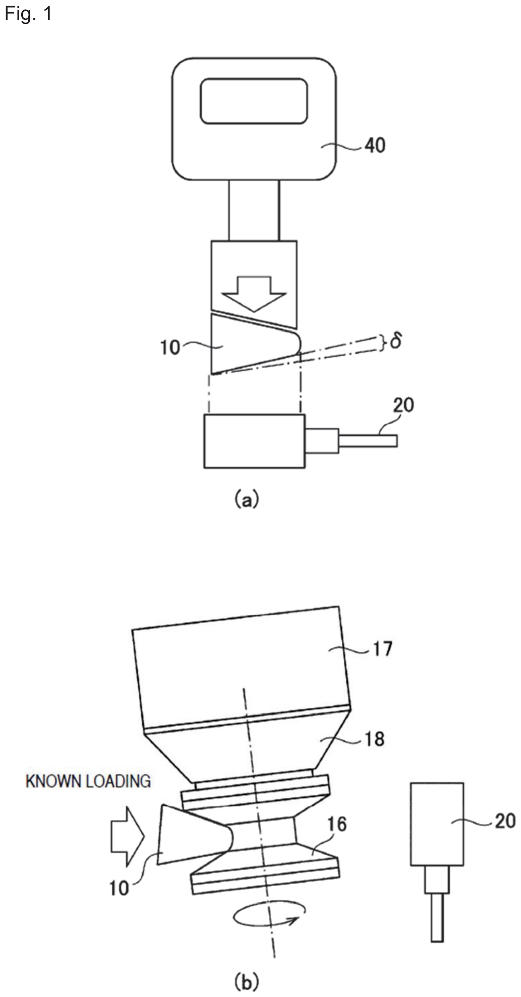

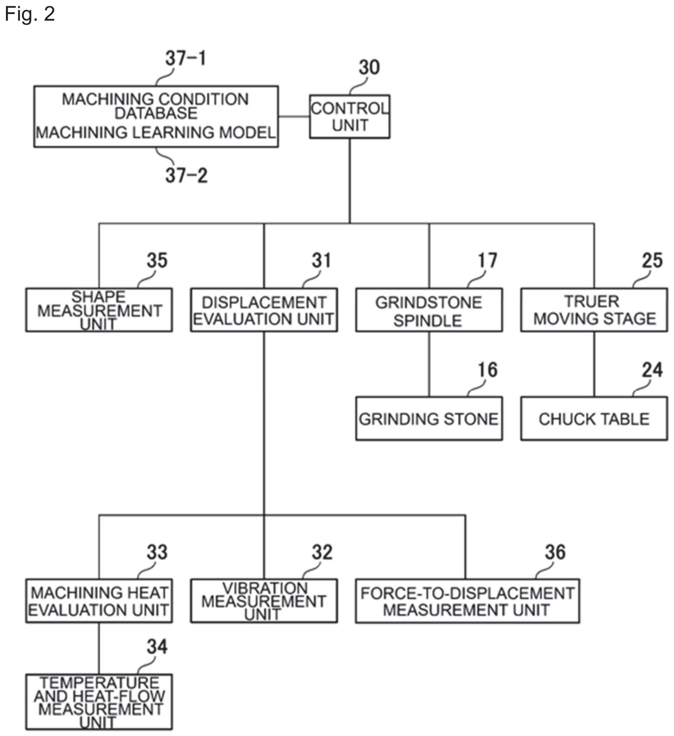

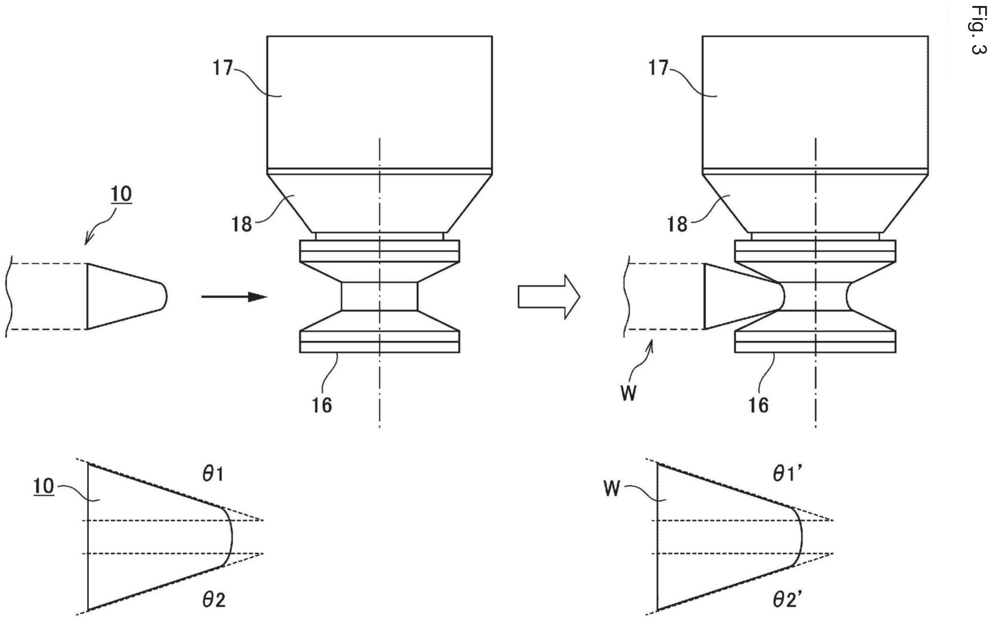

FIG. 1 is a view illustrating a model of force-to-displacement between a truer 10 and a grinding stone 16 according to an embodiment of the present invention, and FIG. 2 is a block diagram illustrating the entire system configuration of a truing device according to the embodiment. FIG. 3 is a view illustrating a procedure of chamfering machining to a wafer W in a device for chamfering.

As illustrated in FIG. 3, in chamfering machining, shape transfer or machining (truing) is performed to the grinding stone 16 by the truer 10, and then the shape of the wafer W is subjected to grinding machining by the grinding stone 16. Referring to FIG. 3, the grinding stone 16 is mounted on a grindstone spindle 17 through a quill 18 and rotates. The upper face angle θ1 and lower face angle θ2 of the end face of the truer 10 are often adjusted slightly smaller than the upper face angle θ1' and lower face angle θ2' of the wafer W as targets (specifically, to approximately 2 to 3 degrees)). In helical grinding, the grooved shape of the grinding stone 16 (target shape) may have vertical asymmetry. In that case, the upper face angle θ1 and lower face angle θ2 of the end face of the truer 10 are adjusted in accordance with the target shape.

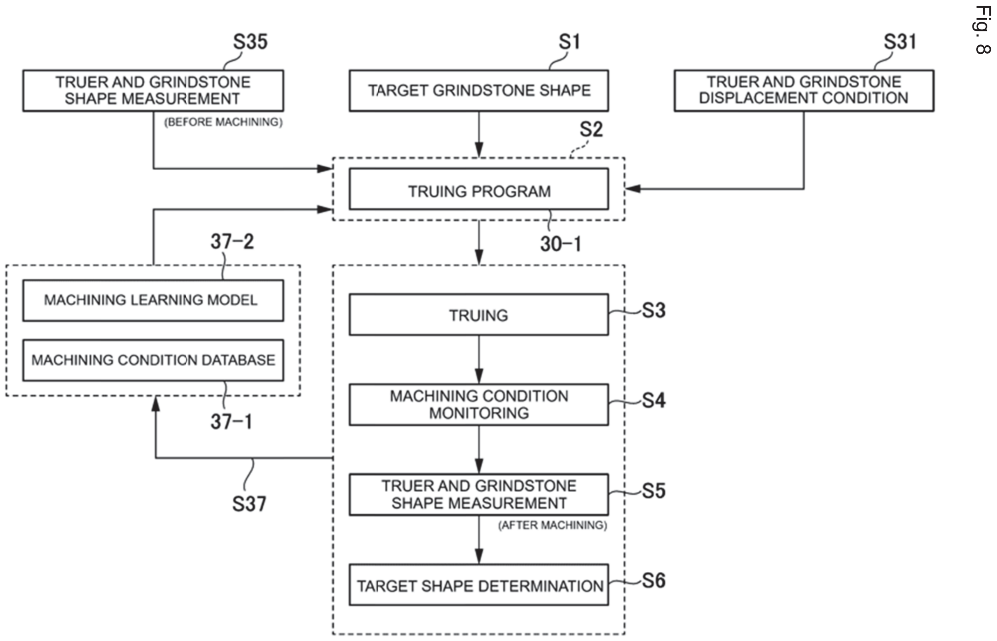

According to a feature of the embodiment, the respective shapes of the truer 10 and the grinding stone 16 measured before machining and the modeled displacement condition between the truer 10 and the grinding stone 16 are reflected to a truing program 30-1 (FIG. 8) for a series of processes for truing.

For example, the condition for truing includes the condition for adjusting the force of pressing the truer 10 against the grinding stone 16. When the truer 10 is pressed against the grinding stone 16, the grinding stone 16 is displaced and the truer 10 is also displaced due to reaction force from the grinding stone 16.

Because machining force is determined based on the condition for truing, preferably, the shape of the truer 10 has a chamfering angle defined by taking into account in advance the displacement of the truer 10 and the displacement of the grinding stone 16 due to the machining force based on the planned condition for truing.

FIG. 1(a) illustrates a configuration for modeling a relationship in the displacement condition of the truer 10, and FIG. 1(b) illustrates a configuration for modeling a relationship in the displacement condition of the grinding stone 16. Referring to FIG. 1(a), for measurement of the displacement condition of the truer 10, a laser displacement meter 20 is installed below the truer 10, and a known load is applied from above to the truer 10 by a tension gauge 40 (or by a force sensor or a weight). Then, the laser displacement meter 20 measures displacement δ. Thus, the displacement condition of the truer 10 (force-to-displacement relationship) is determined as axial displacement.

Referring to FIG. 1(b), for measurement of the displacement condition of the grinding stone 16, the laser displacement meter 20 is installed laterally to the grinding stone 16, and the truer 10 is pressed against the groove of the grinding stone 16 by a known force. Then, the flexural rigidity of the grinding stone 16 is measured to determine the displacement due to bending or torsion of the grinding stone 16.

Thus, the displacement condition of the grinding stone 16 (force-to-displacement relationship) is determined as the displacement due to bending or torsion of the grinding stone 16. Variations in the quality of the truer 10 and the grinding stone 16 are reflected as other displacement conditions. Note that the grinding stone 16 is mounted on the grindstone spindle 17 through the quill 18 and rotates.

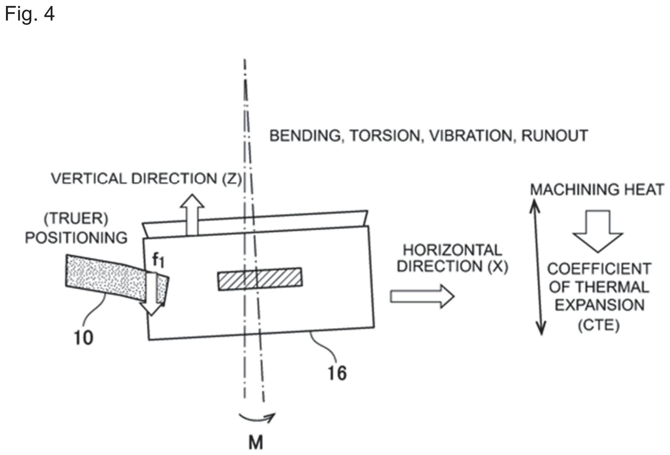

FIG. 4 is an explanatory view for factors related to the precision of machining at the time of truing. As illustrated in FIG. 4, examples of factors related to the precision of machining include the bending, torsion, and vibration of the grinding stone 16, being indicated with arrows, the surface shape and abrasive grain state of the truer 10, force f₁ applied at the time of shape transfer, the deformation of the truer 10, machining heat, the coefficient of thermal expansion (CTE), and positioning between the truer 10 and the grinding stone 16.

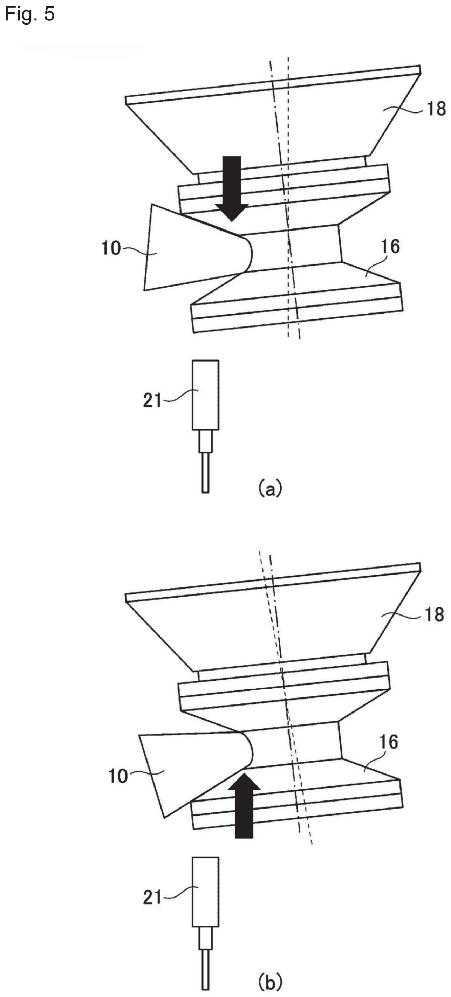

FIG. 5 is an explanatory view illustrating deformation of the truer due to machining force at the time of truing the grinding stone 16 and measurement thereof. FIG. 5(a) illustrates a stress (machining force) applied to the truer 10 at the time of truing the upper face of the grinding stone 16 and the displacement direction of the grinding stone 16 due to the stress. FIG. 5(b) illustrates a stress (machining force) applied to the truer 10 at the time of truing the lower face of the grinding stone 16 and the displacement direction of the grinding stone due to the stress. At the time of truing the upper face of the groove, the truer 10 is pressed against the upper face of the grinding stone 16 and, as its resultant reaction force, a stress in the direction of the arrow is applied to the truer 10. The truer 10 deforms (is displaced) in the direction of the arrow, for example, depending on its material (rigidity). On the other hand, the axis of the grinding stone 16 is, as illustrated in FIG. 5(a), displaces such that the rotational axis inclines from the dot-dash line like the broken line or becomes shifted in the horizontal direction (X). Note that the drawing is schematic and exaggerated for description and thus the actual displacement may be smaller than such displacement as illustrated in the drawing.

The same applies to the time of truing the lower face of the groove. The truer 10 receives a stress in the direction of the arrow and deforms (is displaced). Since the truer 10 is pressed against the grinding stone 16, as illustrated in FIG. 5(b), the axis of the grinding stone 16 inclines from the dot-dash line like the broken line, and becomes shifted in the horizontal direction (X). An eddy-current sensor 21 installed below the grinding stone 16 measures the displacement of the grinding stone 16 due to machining force both during truing the upper face and during truing the lower face.

Note that the relationship in machining force and deformation (displacement) between the truer 10 and the grinding stone 16 is determined in advance as the displacement condition, as illustrated in FIG. 1.

For an improvement in the precision of machining, construction of a machining control model based on analysis of the influence of deformation, based on force, heat, and the like, on the precision of machining, specification of factors having strong influences on performance, and machine learning for automation are required. In particular, positioning between the truer 10 and the grinding stone 16 is a criterion for the above. In a case where a device is in operation for truing and grinding, grinding debris is generated and coolant or the like is continuously supplied to a grinding place, which are harsh conditions for sensing, and thus a robust measurement mechanism is important.

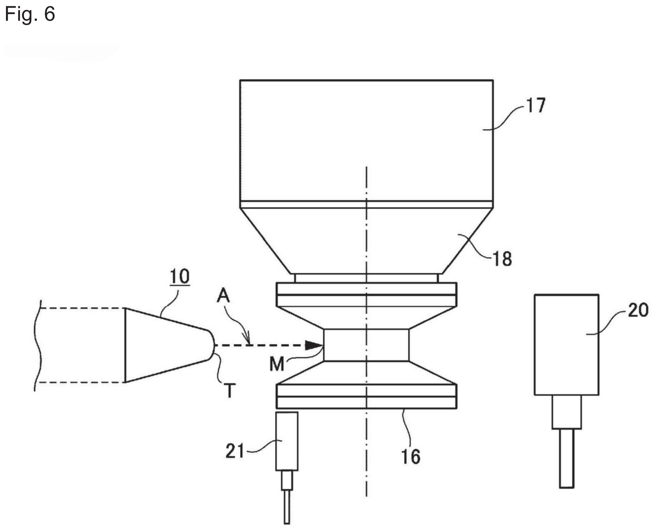

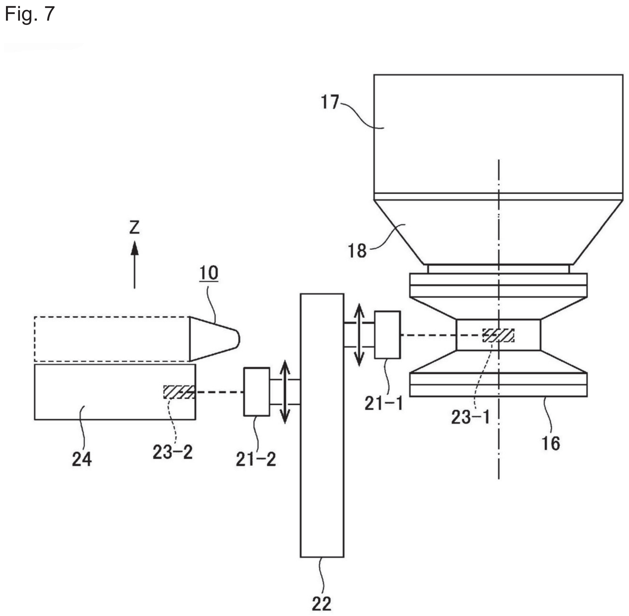

FIG. 6 is an explanatory view for positioning between the truer 10 and the grinding stone 16, and FIG. 7 is a configuration view of a positioning unit. The laser displacement meter 20 measures the two-dimensional cross-sectional shapes of the truer 10 and the grinding stone 16. Based on the two-dimensional cross-sectional shapes measured by the laser displacement meter 20, an end central portion T of the truer 10 and a groove-bottom central position M of the grinding stone 16 are derived. The relative positional relationship between the truer 10 and the grinding stone 16, in which the end central portion T and the groove-bottom central position M are aligned, is set as the reference position. For positioning, the positions of the truer 10 and the grinding stone 16 are moved such that the reference position is fulfilled.

As illustrated in FIG. 7, for positioning between the truer 10 and the grinding stone 16, eddy-current sensors 21-1 and 21-2 detect, respectively, the position of a first conductor 23-1 (or magnetic material) embedded in the grinding stone 16 and the position of a second conductor 23-2 (or magnetic material) embedded in a chuck table 24 that fixes the truer 10.

Referring to FIG. 7, the truer 10 is fixed to the chuck table 24. The second conductor 23-2 (or magnetic material) is embedded in the chuck table 24. The first conductor 23-1 (or magnetic material) is embedded in a groove-bottom central portion of the grinding stone 16. A moving stage 22 has a length measuring function and is equipped with the eddy-current sensors 21-1 and 21-2.

The eddy-current sensor 21-1 is attached to the moving stage 22 movably in a Z direction on the opposite side of the first conductor 23-1 (or magnetic material), and determines, as Z1, the position of the groove-bottom central portion of the grinding stone 16. The eddy-current sensor 21-2 is attached to the moving stage 22 movably in the Z direction on the opposite side of the second conductor 23-2 (or magnetic material), and determines, as Z2, the position of the end central portion T of the truer 10. For positioning between the end central portion T of the truer 10 and the groove-bottom central position M of the grinding stone 16, the truer 10 is moved such that the difference between Z1 and Z2 is a predetermined value, so that the set reference position is fulfilled.

In the system configuration of FIG. 2, a control unit 30 controls, as a machining condition, the incision amount, rotational rate, position, and the like of the truer 10, based on evaluations from a displacement evaluation unit 31, a vibration measurement unit 32, and a machining heat evaluation unit 33. The displacement evaluation unit 31 evaluates the deformation (displacement) of the truer 10 and the deformation (displacement) of the grinding stone 16 at the time of machining, based on a measurement value from a force-to-displacement measurement unit 36.

Based on the modeled displacement condition between the truer 10 and the grinding stone 16 based on known load illustrated in FIG. 1(b), the displacement evaluation unit 31 measures the deformation of the truer 10 and the deformation of the grinding stone 16 during machining (displacements from the no-load state) and then performs rating (numerical conversion based on the criterion). The vibration measurement unit 32 measures the vibration of the truer 10 and the vibration of the grinding stone 16 during machining.

The vibration measurement unit 32 may be in common with the laser displacement meter 20 and the eddy-current sensor 21 illustrated in FIG. 6. That is, vibration may be estimated based on measurement values from the laser displacement meter 20 and the eddy-current sensor 21.

The machining heat evaluation unit 33 evaluates the machining heat of the truer 10 and the machining heat of the grinding stone 16, using a measured temperature value and a measured heat-flow value from a thermocouple and a heat flow meter included in a temperature and heat-flow measurement unit 34.

A shape measurement unit 35 includes, for example, the laser displacement meter 20 and measures at least the two-dimensional cross-sectional shapes of the truer 10 and the grinding stone 16.

The grinding stone 16 is mounted on the grindstone spindle 17. The truer 10 is fixed to the chuck table 24 placed on a truer moving stage 25 such that the rotational axis, the X axis, the Y axis, and the Z axis are made variable.

A machining condition database 37-1 stores a monitoring result of the displacement, vibration, and machining heat of the truer 10 and the displacement, vibration, and machining heat of the grinding stone 16 in association with a measurement result from the shape measurement unit 35 after truing. A machining learning model 37-2 is constructed with the stored result. In addition, the control unit 30 controls grinding heat using a cooling water system.

FIG. 8 is a flowchart of a truing method. The flow further includes a procedure of optimizing the shape of the truer 10.

First, in Step S35, shape measurement is performed on the truer and the grindstone before machining. A target shape of the truer 10 has a chamfering angle of the upper face angle θ1 and the lower face angle θ2 at the end face illustrated in FIG. 3 defined by taking into account the previously determined axial displacement condition of the truer 10 as illustrated in FIG. 1(a).

Next, a target shape is determined for the grinding stone 16 and then is converted into data. (Step S1)

The two-dimensional cross-sectional shapes of the truer 10 and the grinding stone 16 measured before machining in Step S35, the displacement condition between the truer 10 and the grinding stone 16 (e.g., the bending and torsion of the grinding stone 16) modeled in Step S31, and the above target shape are reflected to the truing program 30-1. (Step S2)

Next, truing is performed in Step S3. The truing is performed in accordance with the truing program 30-1. In the truing, the grinding stone 16 is machined by 10 to achieve the target shape.

Note that, in Step S3, as illustrated in FIG. 6, with the position, at which the end central portion T of the truer 10 and the groove-bottom central position M of the grinding stone 16 are aligned, set as the reference position due to measurement by the laser displacement meter 20, the truing is performed.

During the truing, for example, with the displacement evaluation unit 31, the vibration measurement unit 32, the machining heat evaluation unit 33, and the temperature and heat-flow measurement unit 34, the machining condition is monitored. (Step S4)

After the truing, the shapes of the truer 10 and the grinding stone 16 are measured by the laser displacement meter 20 in the shape measurement unit 35 (Step S5), and then a determination is made in quality. The measured respective shapes of the truer 10 and the grinding stone 16 are compared with the respective target shapes, next, when the respective shapes of the truer 10 and the grinding stone 16 fall within the acceptable range, the wafer W is ground by the grinding stone 16, and then a determination is made in quality with respect to the design value (target value) of the edge. (Step S6)

When the truer 10 or the grinding stone 16 subjected to the truing is out of the acceptable range of its target shape or the wafer W ground by the grinding stone 16 subjected to shape transfer is out of the acceptable range of the design value (target value) of the edge, the processing goes back to the process of Step S35 or Step S1. The machining condition and the two-dimensional cross-sectional shapes after machining are associated with each other to be compiled into a database as the machining condition database 37-1 to construct the machining learning model 37-2. (Step S37)

In addition, the monitoring results, as the machining condition during the truing, from the displacement evaluation unit 31, the vibration measurement unit 32, the machining heat evaluation unit 33, the temperature and heat-flow measurement unit 34, and the like are associated with each other and compiled into a database as the machining condition database 37-1. The machining learning model 37-2 is constructed based on the machining condition database 37-1 that is a compiled database. In Step S3, the truing program 30-1 refers to the machining learning model 37-2.

For determination in quality in Step S5 and Step S6, the result accumulated in advance in the machining condition database 37-1 may be used. In addition, for determination of the quality of the grinding stone 16 after machining in Step S5, use of the result accumulated in the machining condition database 37-1 is preferable.

The machining learning model 37-2 serves as a machine learning model that outputs a computer-based evaluated/determined result to data as the result accumulated in the machining condition database 37-1. The truing program 30-1 inputs an inquiry to the machining learning model 37-2 as necessary to obtain an evaluated/determined result.

In the above embodiment, during truing, monitoring is performed, for example, with the displacement evaluation unit 31, the vibration measurement unit 32, the machining heat evaluation unit 33, and the temperature and heat-flow measurement unit 34. Then, due to the truing program 30-1 using the machining condition database 37-1 and the machining learning model 37-2, a high-precision and high-quality grooved shape can be achieved, so that variations in shape can be reduced.

Shape transfer from the truer 10 has been described with FIG. 3. For a further enhancement in precision, the upper portion or lower portion of the groove formed on the grinding stone 16 may be machined by the truer 10 and then the truer 10 may be moved downward or upward, in the thickness direction of the grinding stone 16, relative to the grinding stone 16 to grind the other portion.

During truing, monitoring is performed, for example, with the displacement evaluation unit 31, the vibration measurement unit 32, the machining heat evaluation unit 33, and the temperature and heat-flow measurement unit 34. Construction and use of the machining condition database 37-1 and the machining learning model 37-2 is applicable to a case where the wafer W is formed with a difficult-to-machine material, such as 4H-SiC, a different polytype (e.g., 3C-SiC, 6H-SiC, or 15R-SiC), gallium nitride (GaN), gallium oxide, or AlGaN. Then, according to the embodiment, even when the wafer W is formed with a difficult-to-machine material, an enhancement in quality, particularly, (highly precise shape formation and a uniform surface state (waviness or roughness)) favorable to the post-process can be achieved.

### Reference Signs List

- 10: TRUER
- 16: GRINDING STONE
- 17: GRINDSTONE SPINDLE
- 18: QUILL
- 20: LASER DISPLACEMENT METER
- 21: EDDY-CURRENT SENSOR
- 22: MOVING STAGE
- 23-1: FIRST CONDUCTOR
- 23-2: SECOND CONDUCTOR
- 24: CHUCK TABLE
- 25: TRUER MOVING STAGE
- 30: CONTROL UNIT
- 30-1: TRUING PROGRAM
- 31: DISPLACEMENT EVALUATION UNIT
- 32: VIBRATION MEASUREMENT UNIT
- 33: MACHINING HEAT EVALUATION UNIT
- 34: TEMPERATURE AND HEAT-FLOW MEASUREMENT UNIT
- 35: SHAPE MEASUREMENT UNIT
- 36: DISPLACEMENT MEASUREMENT UNIT
- 37-1: MACHINING CONDITION DATABASE
- 37-2: MACHINING LEARNING MODEL
- 40: TENSION GAUGE
- W: WAFER

## Claims

1. A grinding stone truing method for a grinding stone for use in a device for chamfering a wafer, the grinding stone truing method comprising:
determining a target shape of the grinding stone; and
truing the grinding stone to achieve the target shape, based on respective shapes of a truer and the grinding stone measured at least before machining and a displacement condition indicating a relationship in applied force and displacement between the truer and the grinding stone.

2. The grinding stone truing method according to claim 1, further comprising monitoring, during the truing, displacement, vibration, and machining heat of the truer and displacement, vibration, and machining heat of the grinding stone.

3. The grinding stone truing method according to claim 1 or 2,
wherein the displacement condition of the truer is axial displacement.

4. The grinding stone truing method according to claim 3, wherein the displacement condition of the grinding stone is displacement due to bending or torsion.

5. The grinding stone truing method according to claim 1 or 2, further comprising: measuring the respective shapes of the truer and the grinding stone after the truing; comparing the measured respective shapes of the truer and the grinding stone with the respective target shapes of the truer and the grinding stone; grinding the wafer with the grinding stone when the respective shapes of the truer and the grinding stone fall within an acceptable range; and making a determination in quality.

6. The grinding stone truing method according to claim 2, further comprising: storing, as a machining condition database, a result from the monitoring in association with the respective shapes of the truer and the grinding stone measured after the truing; and constructing a machining learning model based on the machining condition database.

7. A grinding stone truing device for a grinding stone for use in a device for chamfering a wafer, the grinding stone truing device comprising:
a truer moving stage that fixes a truer such that a rotational axis, an X axis, a Y axis, and a Z axis are made variable;
a shape measurement unit that measures respective shapes of the truer and the grinding stone;
a displacement evaluation unit that measures displacement of the truer and displacement of the grinding stone;
a vibration measurement unit that measures vibration of the truer and vibration of the grinding stone;
a machining heat evaluation unit that measures a temperature and a heat flow;
a control unit that controls an incision amount, a rotational rate, and a position of the truer, based on respective measurement results from the displacement evaluation unit, the vibration measurement unit, and the machining heat evaluation unit;
a machining condition database that stores the respective measurement results in association with the respective shapes of the truer and the grinding stone measured after truing; and
a machining learning model constructed based on the machining condition database.

8. The grinding stone truing device according to claim 7, wherein the control unit performs the truing to the grinding stone to achieve a target shape, based on the respective shapes of the truer and the grinding stone measured by the shape measurement unit at least before machining, axial displacement of the truer, and displacement due to bending or torsion of the grinding stone.

## Amended claims

### Amended claims under Art. 19.1 PCT

1. (Amended)
A grinding stone truing method for a grinding stone for use in a device for chamfering a wafer, the grinding stone truing method comprising:
determining a target shape of the grinding stone; and
truing the grinding stone to achieve the target shape while controlling an incision amount, a rotational rate, and a position of a truer to the grinding stone, based on respective shapes of the truer and the grinding stone measured at least before machining and a displacement condition indicating a relationship in applied force at least either in an axial direction or a horizontal direction and displacement between the truer and the grinding stone measured with a load applied.

2. The grinding stone truing method according to claim 1, further comprising monitoring, during the truing, displacement, vibration, and machining heat of the truer and displacement, vibration, and machining heat of the grinding stone.

3. The grinding stone truing method according to claim 1 or 2, wherein the displacement condition of the truer is axial displacement.

4. The grinding stone truing method according to claim 3, wherein the displacement condition of the grinding stone is displacement due to bending or torsion.

5. The grinding stone truing method according to claim 1 or 2, further comprising: measuring the respective shapes of the truer and the grinding stone after the truing; comparing the measured respective shapes of the truer and the grinding stone with the respective target shapes of the truer and the grinding stone; grinding the wafer with the grinding stone when the respective shapes of the truer and the grinding stone fall within an acceptable range; and making a determination in quality.

6. The grinding stone truing method according to claim 2, further comprising: storing, as a machining condition database, a result from the monitoring in association with the respective shapes of the truer and the grinding stone measured after the truing; and constructing a machining learning model based on the machining condition database.

7. (Amended)
A grinding stone truing device for a grinding stone for use in a device for chamfering a wafer, the grinding stone truing device comprising:
a truer moving stage that fixes a truer such that a rotational axis, an X axis, a Y axis, and a Z axis are made variable;
a shape measurement unit that measures respective shapes of the truer and the grinding stone;
a displacement evaluation unit that measures displacement of the truer and displacement of the grinding stone;
a vibration measurement unit that measures vibration of the truer and vibration of the grinding stone;
a machining heat evaluation unit that measures a temperature and a heat flow;
a control unit that controls an incision amount, a rotational rate, and a position of the truer, based on respective measurement results from the displacement evaluation unit, the vibration measurement unit, and the machining heat evaluation unit;
a machining condition database that stores the respective measurement results in association with the respective shapes of the truer and the grinding stone measured after truing; and
a machining learning model constructed based on the machining condition database, wherein
using the machining condition database and the machining learning model, the control unit controls the incision amount, the rotational rate, and the position of the truer to the grinding stone such that the grinding stone has a target shape.

8. The grinding stone truing device according to claim 7, wherein the control unit performs the truing to the grinding stone to achieve the target shape, based on the respective shapes of the truer and the grinding stone measured by the shape measurement unit at least before machining, axial displacement of the truer, and displacement due to bending or torsion of the grinding stone.
